# EUROPEAN PATENT SPECIFICATION

(11) **EP 0 516 453 B1**
(45) Date of publication and mention of the grant of the patent: **13.11.1996**
(21) Application number: 92304917.5
(22) Date of filing: 29.05.1992
(51) Int. Cl.: H03G 3/00, H04Q 7/22

(54) **Control of a power amplifier, particularly in a portable telephone**
Leistungsverstärkungssteuerung, insbesondere für ein tragbares Fernsprechgerät
Commande de gain pour un amplificateur de puissance, particulièrement pour un téléphone portable

(30) Priority: 31.05.1991 JP 155345/91
(43) Date of publication of application: 02.12.1992
(73) Proprietor: NEC CORPORATION, Tokyo (JP)
(72) Inventor: Toba, Hiroyuki, NEC Corporation, Minato-ku, Tokyo (JP)
(74) Representative: Moir, Michael Christopher

(56) References cited:
- GB-A- 2 229 609
- US-A- 3 766 486
- US-A- 4 510 460

## Description

The present invention relates to the control of a power amplifier, particularly in a portable telephone which has a power source battery built into it and whose transmission power is controllable.

### Description of the related art

In a conventional portable telephone of this kind, the output power level of a transmit amplifier is varied stepwise and set according to a control signal sent from a base station to which the portable telephone is connected over a radio channel.

At the base station, the receive field intensity of the electric wave sent from the portable telephone is detected. The detected intensity is determined to belong to which of a plurality of preset classes based on its magnitude. The base station transmits a control signal representing the determined class to the portable telephone over a control channel different from a speech channel. The portable receives and demodulates the transmitted control signal to reproduce the control signal. Upon the reproduced control signal, the portable telephone controls the output level of its transmit power amplifier in stepwise variation.

The transmission power of such a portable telephone is controlled in order to keep the portable telephone, when in use, within the range of sufficient receive field intensity to maintain communication with the base station even if the portable telephone shifts in position. On the other hand, the exhaustion of the power source battery can be saved if a control circuit (for example, the output power control circuit for power amplifier described in U.S. Patent No. 4,510,460) is used to increase or decrease the power consumption of the transmission power amplifier according to the varying transmission power requirement, because the power consumption of the transmission power amplifier can be reduced when the portable telephone does not need high transmission power. The number of the preset classes (five or six, for instance) in the conventional portable telephone described above, however, is set only with a view to maintaining communication when the telephone shifts its position, and is insufficient for substantially saving the power consumption of the transmission power amplifier. Usually the transmission power control according to the class of receive field intensity is performed by about 4 dB steps, but if the receive field intensity in a given class is greater than the center value of the class, the transmission power can be further reduced by 2 dB without letting the receive field intensity go out of the required range, and the power consumption of the transmission power amplifier can be thereby reduced to about two thirds. Since the power consumed by the transmission power amplifier accounts for a considerable proportion of a total power consumption of the portable telephone, it is desirable to control the transmission power more finely to such an extent.

An object of the present invention, therefore, is to provide a method of and apparatus for controlling a power amplifier, particularly for a portable telephone so as to control the transmission power of the telephone transmit amplifier by varying it in finer classes than the classes of field intensity instructed by a base station.

In one aspect, the invention provides a method of controlling the output power of a power amplifier, comprising the steps of:
(a) extracting a power control signal from a received radio signal;
(b) detecting the field intensity of said received radio signal to produce an intensity signal;
characterised by the steps of
(c) controlling the output power of said power amplifier by setting the output power of said power amplifier to one of a plurality of classes which is represented by said power control signal, each of said plurality of classes being divided into a plurality of subclasses; and
(d) adjusting the output power of said power amplifier by setting the output power of said power amplifier to one of a said plurality of subclasses which is represented by said intensity signal.

In another aspect there is provided apparatus for controlling the power of a power amplifier comprising:
means for extracting a power control signal from a received radio signal;
means for detecting the field intensity of said received radio signal to produce an intensity signal;
characterised in that said apparatus provides
means responsive to said power control signal for controlling said power amplifier by setting the output power of said power amplifier to one of a plurality of classes which is represented by said power control signal, each of said plurality of classes being divided into a plurality of subclasses; and
means responsive to said intensity signal for adjusting the gain of said power amplifier to one of said plurality of subclasses.

The invention further provides a portable telephone comprising:
amplifier means for amplifying a transmit signal;
means for detecting a level control signal from a received signal which is transmitted from a base station;
means for detecting the field intensity of said received signal to produce an intensity signal;
characterised in that said telephone provides
means responsive to said level control signal for setting the gain of said amplifier means to one of a plurality of classes which is represented by said level control signal, each of said plurality of classes being divided into a plurality of subclasses; and
means responsive to said intensity signal for adjusting the gain of said amplifier means to one of said plurality of subclasses.

Also according to the invention, there is provided a portable telephone equipped with a receiver section comprising a demodulation circuit for demodulating a modulated signal which is received and generating a first data unit indicating to which of a plurality preset classes a receive field intensity of the field intensity of the base station belongs, and a level detecting circuit for envelope-detecting said modulated signal which has been recieved and generating a second data unit representing the receive field intensity of said modulated signal;
characterised by
a transmission power control section for generating a control voltage corresponding to one of a plurality of subclasses, said subclasses corresponding to a second data unit and being the result of a subdivision of each of the received field intensity classes corresponding to the first data data unit;
a control circuit for controlling the amperage of a current supplied from a power source according to said control voltage; and
a transmitter section for amplifying a transmit signal with an amplification gain, which is controlled according to the amperage of the controlled current, and outputting the amplified signal.

The portable telephone according to the present invention is capable of variably controlling the transmission output in finer subclasses than the class defined by said first data unit from the base station and of accordingly finer control of the power consumption by the transmitter section. Therefore, it contributes to reducing the exhaustion and extending the effective life of the power source battery.

The above-mentioned and other objects, features and advantages of the invention will become more apparent from the following detailed description when taken in conjunction with the accompanying drawings, wherein :
FIG. 1 is a block diagram illustrating a preferred embodiment of the invention;
FIG. 2 is a diagram of characteristics for describing the operation of the preferred embodiment of the invention; and
FIG. 3 is a circuit diagram illustrating the configuration of the control circuit and the transmitter section of the preferred embodiment of the invention.

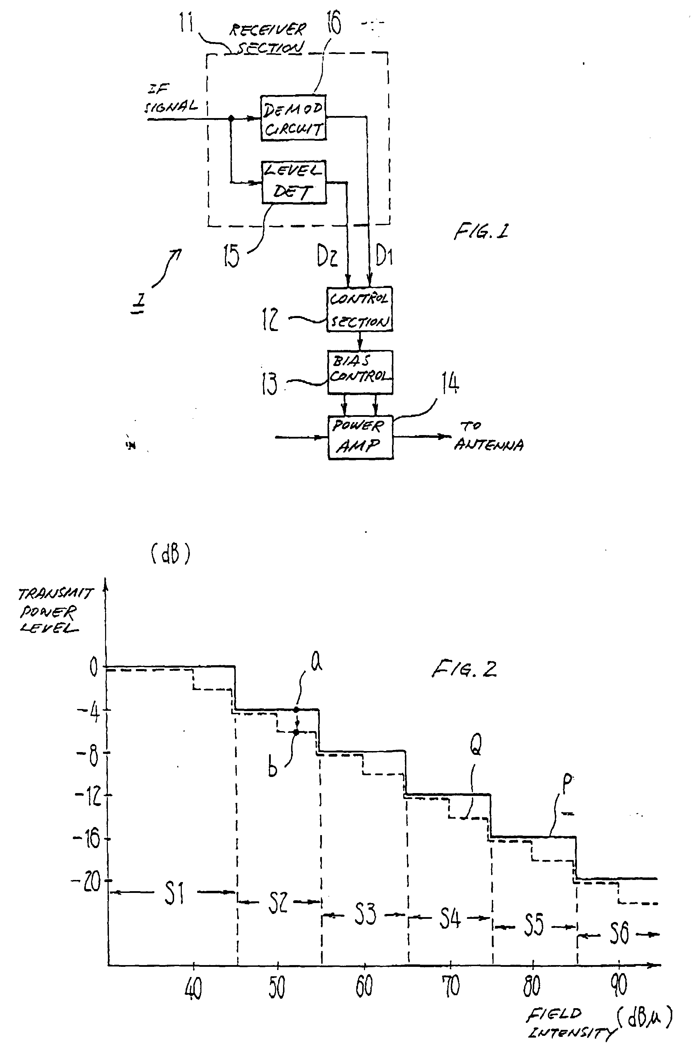

Referring to FIG. 1, a portable telephone 1 includes a receiver section 11 which receives an intermediate frequency (IF) signal obtained by passing through an amplifier and a mixer (neither shown) a radio frequency (RF) signal sent from a base station over a radio control channel. The receiver section 11 reproduces data D1, representing the receive field intensity class at the base station, by demodulating the IF signal and data D2 representing the receive field intensity of the RF signal. The portable telephone also includes a control section 12 for generating a voltage signal for controlling the transmission power according to the combination of the data D1 and D2. In response to the voltage signal, a bias control circuit 13 controls the bias current of the power source of a power amplifier 14 and thereby to control the output power level of amplifier 14.

A level detecting circuit 15 of receiver section 11 detects the level of the RF signal by enveloppe-detecting the IF signal and produces an 8-bit digital signal representing the IF signal level. The 8-bit digital signal is provided to the control section 12 as the data D2. A demodulating circuit 16 demodulates the IF signal to reproduce the data D1 representing the receive field intensity which is detected at the base station. The data D2 are also supplied to the control section 12.

In FIG. 2, the abscissa represents the intensity of the receive field at the base station (in dBµ) and the ordinate, the transmission power the portable telephone is to set (in dB with reference to the maximum output power). Six classes of receive field intensity are set, including: S1 of below 45 dBµ, S2 of 45 to 55 dbµ, S3 of 55 to 65 dBµ, S4 of 65 to 75 dBµ, S5 of 75 to 85 dBµ, and S6 of above 85 dBµ. At the base station, the receive field intensity (in dBµ) of the portable telephone is figured out by detecting the level of the receive signal from the portable telephone and converting an 8-bit data, for example, D1. The base station transmits the data D1 to the portable telephone over the radio control channel, as well known in the art. Upon receiving this transmitted radio signal, the receiver section 11 demodulates the radio signal to reproduce the original data D1 as stated above. At the same time, the level detecting circuit detects the receive field intensity of the radio signal to produce the data D2, as also stated above. Since the data D1 merely indicates which of the classes S1 to S6 the intensity belongs to, only a control characteristic Pi represented by the solid line in FIG. 2 could be obtained if the transmission power were controlled by sending the data D1 alone. However, if the data D2 is also used in combination as in this embodiment, the resolution becomes higher. Accordingly, the applicable one of the classes S1 through S6 can be further subdivided, and it can be indicated which of the subclasses the intensity belongs to.

In this preferred embodiment, each of the classes S1 through S6 is further subdivided into two and, if the receive field intensity of any subclass is higher than the center intensity of each of the original classes S1 through S6, a subclass immediately below the level is instructed by the base station to give a control characteristic Q represented by the broken line in FIG. 2. Thus, while the control characteristic P is for setting stepwise the transmission power at 4 dB intervals for the classes S1 through S6, the control characteristic Q is for further setting stepwise the transmission power at half those intervals, i.e. each of 2 dB.

The control section 12, having a memory in which are stored in advance values of control voltage to be given to the bias control circuit 13 according to the subclass of receive field intensity represented by the combination of the data D1 and D2, converts a digital code read out of the memory into an analog signal by providing the data D1 and D2 as the read address, and sends the analog signal to the control circuit 13 as the control voltage through a buffer amplifier.

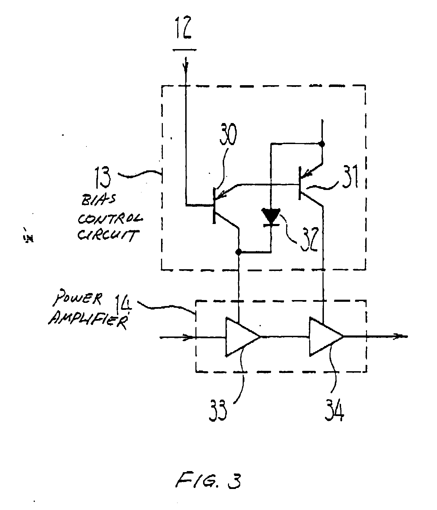

Referring now to FIG. 3, while the bias control circuit 13 and the power amplifier 14 is disclosed in the above cited U.S. Pat. No. 4,510,460, a brief description will now be given in order to better understand the present invention. U.S. Pat. No, 4,510,460 is incorporated herein. The biasing parts of the two circuits are not shown here. When the control voltage from the control section 12 is low, the source current supplied from the bias control circuit 13 to the power amplifier 14 becomes greater, and the amplification gain of the amplifier 14 rises. Conversely, if the control voltage is raised, the source current from the bias control circuit 13 to the amplifier 14 is reduced, and the amplification gain of the amplifier 14 also drops. This circuit configuration has an advantage that the power efficiency will not be significantly affected by any increase or decrease in amplification gain. In FIG. 3, the bias control circuit 13 is so structured as to connect a D.C. power supply to the power input terminal of an output amplifier 34 of power amplifier 14 via the emitter and collector of a transistor 31, to connect the base of the transistor 31 to the power input terminal of an input amplifier 33 of the transmitter section 14 via the emitter and collector of a transistor 30, and to connect the D.C. power supply via a diode 32 to the power input terminal of the input amplifier 33 in the forward direction.

The input and output amplifiers 33 and 34 are high frequency amplifiers each using a field effect transistor (FET), to whose drain is fed as the bias voltage the source voltage supplied from the control circuit 13 to each power input terminal.

The control voltage, provided from the control section 12 when the telephone is in operation, is at its lowest when the receive field intensity of the base station is in its lowest class (S1 in FIG. 2), and rises stepwise as the receive field intensity of the base station shifts to a higher class. The step by which it rises is subdivided in this preferred embodiment, as described above, by using the data D2 representing the receive field intensity of the portable telephone.

When the control voltage at its lowest, i.e. when the power amplifier 14 is so controlled as to provide the maximum output, both transistors 30 and 31 are saturated, and the voltage drop from the D.C. power source to the collector of the transistor 30 becomes smaller than the voltage drop of the diode 32 in the forward direction. In this case, the diode 32 is turned off, and the power supply to the input amplifier 33 takes place via the transistors 30 and 31. Whereas a considerably large base current (about 1/10 of the collector current of the transistor 31) flows through the transistor 31, the current amplifying action of the transistor 30 makes it sufficient to supply only a small base current from the control section 12 to the transistor 30 and, as the collector current of the transistor 30 is utilized as the source current to the input amplifier 33, only a small power supply from the control section 12 to the control circuit 13 will suffice, resulting in transmission power control at a high power effieiency.

As the control voltage provided from the control section 12 becomes increasingly higher than the aforementioned lowest level, the collector current of the transistor 30 drops. On the other hand, the voltage drop from the D.C. power source to the collector of the transistor 30 becomes greater than the voltage drop of the diode 32 in the forward direction, and the diode 32 is turned on. When the diode 32 is turned on, power begins to be supplied to the input amplifier 33 via the diode 32; the current flowing from the control circuit 12 to the base of the transistor 30 decreases; and, correspondingly, the collector current of the transistor 31, i.e. the current supplied to the output amplifier 34, also decreases to reduce the transmission power. When the transmission power from the power amplifier 14 is reduced in this way, the current supplied from the D.C. power source to the power amplifier 14 also decreases, and accordingly a reduction of the transmission output would invite no significant deterioration in power efficiency, which instead remains high in a broad range of operation from the maximum to a low output.

As hitherto described, the control characteristic Q shown in FIG 2 can be realized by this preferred embodiment. When, for instance, the data D1 sent from the base station represents the class S2, if the data D2 generated by the receiving section 11 represents a higher value than the center intensity of the class S2, the transmission power is set at -6 dB as indicated by a point b on the control characteristic Q in this embodiment, while it would be set at -4 dB as indicated by point a on the control characteristic P in the conventional portable telephone since the transmission power at the point b is higher than at a point interpolating the two ends of the class S2 of the control characteristic P, no trouble can occur to the continuation of communication even at this point b and, since the transmission power can be 2 dB lower than with a conventional circuit, the source current to the power amplifier 14 can be reduced to about two thirds.

Although each of the receive field intensity classes at the base station is further bisected at on the portable receiver side in this preferred embodiment, it may be obvious to persons skilled in the art that the way of subdivision of such classes in the portable telephone, instead of being limited to bisecting, can be readily altered to finer subdivision into three or more parts with the same effect as this particular embodiment.

## Claims

1. A method of controlling the output power of a power amplifier (14), comprising the steps of:
(a) extracting a power control signal (D1) from a received radio signal;
(b) detecting the field intensity of said received radio signal to produce an intensity signal (D2);
characterised by the steps of
(c) controlling the output power of said power amplifier (14) by setting the output power of said power amplifier to one of a plurality of classes (S1 - S6) which is represented by said power control signal (D1), each of said plurality of classes being divided into a plurality of subclasses; and
(d) adjusting the output power of said power amplifier (14) by setting the output power of said power amplifier to one of a said plurality of subclasses which is represented by said intensity signal (D2).

2. Apparatus for controlling the power of a power amplifier (14) comprising:
means (16) for extracting a power control signal (D1) from a received radio signal;
means (15) for detecting the field intensity of said received radio signal to produce an intensity signal (D2);
characterised in that said apparatus provides
means (12,13) responsive to said power control signal for controlling said power amplifier by setting the output power of said power amplifier to one of a plurality of classes which is represented by said power control signal, each of said plurality of classes being divided into a plurality of subclasses; and
means (12,13) responsive to said intensity signal for adjusting the gain of said power amplifier to one of said plurality of subclasses.

3. A portable telephone (1) comprising:
amplifier means (14) for amplifying a transmit signal;
means (16) for detecting a level control signal (D1) from a received signal which is transmitted from a base station;
means (15) for detecting the field intensity of said received signal to produce an intensity signal (D2);
characterised in that said telephone provides
means (12,13) responsive to said level control signal for setting the gain of said amplifier means to one of a plurality of classes (S1-S6) which is represented by said level control signal, each of said plurality of classes being divided into a plurality of subclasses; and
means (12,13) responsive to said intensity signal for adjusting the gain of said amplifier means to one of said plurality of subclasses.

4. A portable telephone (1) as claimed in Claim 3, characterised in that said plurality of subclasses includes two levels.

5. A portable telephone (1) equipped with a receiver section (11) comprising a demodulation circuit (16) for demodulating a modulated signal which is received and generating a first data unit (D1) indicating to which of a plurality preset classes a receive field intensity of the field intensity of the base station belongs, and a level detecting circuit (15) for envelope-detecting said modulated signal which has been received and generating a second data unit (D2) representing the receive field intensity of said modulated signal;
characterised by
a transmission power control section (12) for generating a control voltage corresponding to one of a plurality of subclasses, said subclasses corresponding to a second data unit and being the result of a subdivision of each of the received field intensity classes corresponding to the first data unit;
a control circuit (13) for controlling the amperage of a current supplied from a power source according to said control voltage; and
a transmitter section (14) for amplifying a transmit signal with an amplification gain, which is controlled according to the amperage of the controlled current, and outputting the amplified signal.

6. A portable telephone (1), as claimed in Claim 5, characterised in that said control section (12) has a memory in which digital codes representing said control voltages, corresponding to the combinations of said first and second data units, are stored in advance, and a digital-to-analog converter for providing said first and second data units as the read address signal, converting into an analog voltage the digital code read out of the memory, and sending out said analog as said control voltage.

7. A portable telephone (1), as claimed in Claim 5 or Claim 6, characterised in that said transmitter section (14) has one output amplifier and at least one stage of preamplifier connected to the stage immediately preceding said output amplifier, and
said control circuit (13) has a first transistor whose emitter and collector are connected between said power source and the power input terminal of said output amplifier; one second transistor or more the emitter and the collector of each of which are connected between the base of the first transistor and the power input terminal of said preamplifier; and one diode or more connected between said power source and the power input terminal of said preamplifier in the forward direction, said control voltage being fed to the base of said second transistor or transistors.

## Patentansprüche

1. Verfahren zum Steuern der Ausgangsleistung eines Leistungsverstärkers (14), das die Schritte aufweist:
(a) ein Leistungssteuersignal (D1) aus einem empfangenen Radiosignal zu gewinnen;
(b) die Feldintensität des empfangenen Radiosignals zu detektieren, um ein Intensitätssignal (D2) zu erzeugen;
gekennzeichnet durch die Schritte
(c) die Ausgangsleistung des Leistungsverstärkers (14) durch Einstellen der Ausgangsleistung des Leistungsverstärkers auf eine einer Vielzahl von Klassen (S1 - S6), die durch das Leistungssteuersignal (D1) repräsentiert wird, wobei jede der Vielzahl von Klassen in eine Vielzahl von Unterklassen aufgeteilt ist; und
(d) die Ausgangsleistung des Leistungsverstärkers (14) durch Einstellen der Ausgangsleistung des Leistungsverstärkers auf eine der Vielzahl von Unterklassen einzustellen, die durch das Intensitätssignal (D2) repräsentiert wird.

2. Vorrichtung zum Steuern der Leistung eines Leistungsverstärkers (14), die aufweist: Mittel (16) zum Gewinnen eines Leistungssteuersignals (D1) von einem empfangenen Radiosignal;
Mittel (15) zum Detektieren der Feldintensität des empfangenen Radiosignals, um ein Intensitätsignal (D2) zu erzeugen;
dadurch gekennzeichnet, daß die Vorrichtung zur Verfügung stellt
Mittel (12, 13), die auf das Leistungssteuersignal zum Steuern des Leistungsverstärkers reagieren, indem die Ausgangsleistung des Leistungsverstärkers auf eine einer Vielzahl von Klassen eingestellt wird, die durch das Leistungssteuersignal repräsentiert wird, wobei jede der Vielzahl von Klassen in eine Vielzahl von Unterklassen aufgeteilt ist; und
Mittel (12, 13), die auf das Intensitätssignal reagieren, um die Verstärkung des Leistungsverstärkers auf eine der Vielzahl von Unterklassen einzustellen.

3. Tragbares Telefon (1), das aufweist:
Verstärkermittel (14) zum Verstärken eines Sendesignals;
Mittel (16) zum Detektieren eines Pegelsteuersignals (D1) von einem empfangenen Signal, das von einer Basisstation gesendet wird;
Mittel (15) zum Detektieren der Feldintensität des empfangenen Signals, um ein Intensitätssignal (D2) zu erzeugen;
dadurch gekennzeichnet, daß das Telefon zur Verfügung stellt
Mittel (12, 13), die auf das Pegelsteuersignal zum Einstellen der Verstärkung des Verstärkermittels auf eine einer Vielzahl von Klassen (S1 - S6) reagieren, die durch das Pegelsteuersignal repräsentiert wird, wobei jede der Vielzahl von Klassen in eine Vielzahl von Unterklassen aufgeteilt ist; und
Mittel (12, 13), die auf das Intensitätssignal zum Einstellen der Verstärkung des Verstärkermittels auf eine der Vielzahl von Unterklassen reagieren.

4. Tragbares Telefon (1) gemäß Anspruch 3, dadurch gekennzeichnet, daß die Vielzahl von Unterklassen zwei Pegel einschließt.

5. Tragbares Telefon (1), das mit einem Empfängerabschnitt (11) ausgerüstet ist, der eine Demodulationsschaltung (16) zum Demodulieren eines modulierten Signals, das empfangen wird, und zum Erzeugen einer ersten Dateneinheit (D1), die anzeigt, zu welcher einer Vielzahl von voreingestellten Klassen eine Empfangsfeldintensität der Feldintensität der Basisstation gehört, und eine Pegeldetektionsschaltung (15) zur Hüllkurvendetektion des modulierten Signals, das empfangen worden ist, und zum Erzeugen einer zweiten Dateneinheit (D2) aufweist, die die Empfangsfeldintensität des modulierten Signals repräsentiert;
gekennzeichnet durch
einen Sendeleistungssteuerabschnitt (12) zum Erzeugen einer Steuerspannung, die einer einer Vielzahl von Unterklassen entspricht, wobei die Unterklassen einer zweiten Dateneinheit entsprechen und das Ergebnis einer Unterteilung jeder der Intensitätsklassen des empfangenen Felds entsprechend der ersten Dateneinheit sind; eine Steuerschaltung (13) zum Steuern der Stromstärke eines Stroms, der von einer Leistungsquelle geliefert wird, entsprechend der Steuerspannung; und
einen Senderabschnitt (14) zum Verstärken eines Sendesignals mit einer Verstärkung, die entsprechend der Stromstärke des gesteuerten Stroms gesteuert wird, und zum Ausgeben des verstärkten Signals.

6. Tragbares Telefon (1) nach Anspruch 5, dadurch gekennzeichnet, daß der Steuerabschnitt (12) einen Speicher, in dem digitale Codes, die die Steuerspannungen repräsentieren, entsprechend den Kombinationen der ersten und zweiten Dateneinheiten vorher gespeichert sind, und einen Digital-Analog-Wandler zum Schaffen der ersten und zweiten Dateneinheiten als das Leseadreßsignal aufweist, der den Digitalcode, der aus dem Speicher ausgelesen ist, in eine Analogspannung umwandelt und die analoge Größe als die Steuerspannung aussendet.

7. Tragbares Telefon (1) nach Anspruch 5 oder 6, dadurch gekennzeichnet, daß der Sendeabschnitt (14) einen Ausgangsverstärker und wenigstens eine Vorverstärkerstufe aufweist, die mit der Stufe unmittelbar vor dem Ausgangsverstärker verbunden ist, und
daß die Steuerschaltung (13) einen ersten Transistor, dessen Emitter und Kollektor zwischen der Leistungsquelle und dem Leistungseingangsanschluß des Ausgangsverstärkers verbunden sind, einen zweiten Transistor oder mehr, von denen jeweils der Emitter und der Kollektor zwischen der Basis des ersten Transistors und dem Leistungseingangsanschluß des Vorverstärkers verbunden sind; und eine Diode oder mehrere aufweist, die zwischen der Leistungsquelle und dem Leistungseingangsanschluß des Vorverstärkers in Vorwärtsrichtung verbunden sind, wobei die Steuerspannung der Basis des zweiten Transistors oder der zweiten Transistoren zugeführt wird.

## Revendications

1. Procédé de commande de la puissance de sortie d'un amplificateur de puissance (14), comprenant les étapes de :
(a) extraction d'un signal de commande de puissance (D1) à partir d'un signal radio reçu ;
(b) détection de l'intensité de champ dudit signal radio reçu afin de produire un signal d'intensité (D2),
caractérisé par les étapes de :
(c) commande de la puissance de sortie dudit amplificateur de puissance (14) en établissant la puissance de sortie dudit amplificateur de puissance à l'une d'une pluralité de classes (S1 - S6) qui est représentée par ledit signal de commande puissance (D1), chacune de ladite pluralité de classes étant divisée en une pluralité de sous-classes ; et
(d) réglage de la puissance de sortie dudit amplificateur de puissance (14) en établissant la puissance de sortie dudit amplificateur de puissance à l'une d'une dite pluralité de sous-classes qui est représentée par ledit signal d'intensité (D2).

2. Appareil de commande de la puissance d'un amplificateur de puissance (14) comprenant :
des moyens (16) pour extraire un signal de commande de puissance (D1) à partir d'un signal radio reçu;
des moyens (15) pour détecter l'intensité de champ dudit signal radio reçu afin de produire un signal d'intensité (D2),
caractérisé en ce que ledit appareil prévoit :
des moyens (12, 13) sensibles audit signal de commande de puissance pour commander ledit amplificateur de puissance en établissant la puissance de sortie dudit amplificateur de puissance à l'une d'une pluralité de classes qui est représentée par ledit signal de commande de puissance, chacune de ladite pluralité de classes étant divisée en une pluralité de sous-classes ; et
des moyens (12, 13) sensibles audit signal d'intensité pour régler le gain dudit amplificateur de puissance à l'une de ladite pluralité de sous-classes.

3. Téléphone portable (1) comprenant :
des moyens d'amplificateur (14) pour amplifier un signal d'émission ;
des moyens (16) pour détecter un signal de commande de niveau (D1) à partir d'un signal reçu qui est émis depuis une station de base ;
des moyens (15) pour détecter l'intensité de champ dudit signal reçu afin de produire un signal d'intensité (D2),
caractérisé en ce que ledit téléphone prévoit :
des moyens (12, 13) sensibles audit signal de commande de niveau pour établir le gain desdits moyens d'amplificateur à l'une d'une pluralité de classes (S1 - S6) qui est représentée par ledit signal de commande de niveau, chacune de ladite pluralité de classes étant divisée en une pluralité de sous-classes ; et
des moyens (12, 13) sensibles audit signal d'intensité pour régler le gain desdits moyens d'amplificateur à l'une de ladite pluralité de sous-classes.

4. Téléphone portable (1) selon la revendication 3, caractérisé en ce que ladite pluralité de sous-classes inclut deux niveaux.

5. Téléphone portable (1) équipé d'une section de récepteur (11) comprenant un circuit de démodulation (16) pour démoduler un signal modulé qui est reçu et pour générer une première unité de données (D1) indiquant à laquelle d'une pluralité de classes pré-établies une intensité de champ reçue de l'intensité de champ de la station de base appartient et un circuit de détection de niveau (15) pour détecter du point de vue de l'enveloppe ledit signal modulé qui a été reçu et pour générer une seconde unité de données (D2) représentative de l'intensité de champ reçue dudit signal modulé,
caractérisé par :
une section de commande de puissance d'émission (12) pour générer une tension de commande correspondant à l'une d'une pluralité de sous-classes, lesdites sous-classes correspondant à une seconde unité de données et étant le résultat d'une subdivision de chacune des classes d'intensité de champ reçue correspondant à la première unité de données ;
un circuit de commande (13) pour commander l'ampérage d'un courant appliqué depuis une source d'alimentation conformément à ladite tension de commande ; et
une section d'émetteur (14) pour amplifier un signal d'émission à l'aide d'un gain d'amplification, qui est commandé conformément à l'ampérage du courant commandé, et pour émettre en sortie le signal amplifié.

6. Téléphone portable (1) selon la revendication 5, caractérisé en ce que ladite section de commande (12) comporte une mémoire dans laquelle des codes numériques représentant lesdites tensions de commande, correspondant aux combinaisons desdites première et seconde unités de données, sont stockés à l'avance, et un convertisseur numérique-analogique pour produire lesdites première et seconde unités de données en tant que signal d'adresse de lecture, pour convertir en une tension analogique le code numérique lu dans la mémoire et pour envoyer ladite tension analogique en tant que dite tension de commande.

7. Téléphone portable (1) selon la revendication 5 ou 6, caractérisé en ce que ladite section d'émetteur (14) comporte un amplificateur de sortie et au moins un étage de préamplificateur connecté à l'étage précédant immédiatement ledit amplificateur de sortie ; et
ledit circuit de commande (13) comprend un premier transistor dont l'émetteur et le collecteur sont connectés entre ladite source d'alimentation et la borne d'entrée de puissance dudit amplificateur de sortie ; un second transistor ou plus, l'émetteur et le collecteur de chacun étant connectés entre la base du premier transistor et la borne d'entrée de puissance dudit préamplificateur ; et une diode ou plus connectée entre ladite source d'alimentation et la borne d'entrée de puissance dudit préamplificateur en sens direct, ladite tension de commande étant appliquée sur la base dudit second transistor ou desdits seconds transistors.
